# EUROPEAN PATENT APPLICATION

(11) **EP 2 128 985 A1**
(43) Date of publication of application: **02.12.2009**
(21) Application number: 08009922.9
(22) Date of filing: 30.05.2008
(51) Int. Cl.: H03K 17/96

(54) **Input device**

(71) Applicant: Electrolux Home Products Corporation N.V., 1930 Zaventem (BE)
(72) Inventor: Jeanneteau, Laurent, 60200 Compiègne (FR); Rigolle, Thibaut, 47100 Forli (IT); Nostro, Massimo, 47100 Forli (IT); Grassano, Andrea, 47100 Forli (IT)
(74) Representative: Schröer, Gernot H.

(57) **Abstract**

The invention relates to an input device (1) for a home appliance for operation with a finger (4), comprising
a) sensitive keys (11 - 22) arranged below a surface in a two-dimensional array (2),
b) wherein a key voltage based on the nearness of the finger (4) is genetatable by each sensitive key (11 - 22) dependant on the distance from the key and the size of the finger (4),
c) wherein in a detection unit (8) all key voltages are comparable and
d) wherein in the detection unit (8) the position of the finger (4) is detectable.

Furthermore, the invention relates to a method for data input for a home appliance for operation with a finger (4), especially for an input device according to the invention,
a) with sensitive keys (11 - 22) arranged below a surface in a two-dimensional array (2),
b) wherein a key voltage is generated based on the nearness of the finger by each sensitive key (11 - 22) dependant on the distance from the key and the size of the finger (4),
c) wherein all generated key voltages are compared,
d) wherein the position of the finger is detected,
e) wherein preferably the detection is repeated after a predefined time span and/or
f) wherein preferably a movement of the finger (4) is detected.

## Description

The invention relates to an input device for a home appliance for operation with a finger.

For home appliances, keys or switches are known for operating the appliance with a finger. However, single keys or switches are not able to detect a two dimensional position of a finger or a movement of a finger.

Therefore, it is an object of the invention, to propose a new input device, which overcomes the named disadvantage.

This object is solved by an input device according to claim 1 and a method for data input according to claim 8. Advantageous embodiments are described particularly in the dependent claims.

According to claim 1, the invention relates to an input device for a home appliance for operation with a finger, comprising
a) sensitive keys arranged below a surface in a two-dimensional array,
b) wherein a key voltage based on the nearness of the finger is generatable by each sensitive key dependant on the distance from the key and the size of the finger,
c) wherein in a detection unit all key voltages are comparable and
d) wherein in the detection unit the position of the finger is detectable.

The input device according to the invention allows the detection of a two dimensional position of a finger on a surface, as well as the detection of the movement of the finger. The input device can be operated by small fingers as well as by large fingers with the same result. The detection is possible with an at least relatively good resolution.

Preferably, the detection of the position is repeatable after a predefined time span, especially 100 ms, and/or a movement of the finger is detectable, preferably based on a fixed and/or an arbitrary starting point.

In an advantageous embodiment, the keys are at least substantially circular. As an alternative, keys which are at least substantially rectangular or with another form are possible.

Preferably, the position of the finger is detectable by the comparing the generated key voltages and determining the largest key voltage. This eases it to refer to relative voltages or values which are independent from the size of a finger.

In an advantageous embodiment, an acceleration of the finger movement is detectable, especially by comparing three succeeding positions of the finger. By this, additional information can be submitted by a movement of the finger.

Preferably, the input device is integrated into a cooking device, particularly a, preferably transparent, glass of a cooking hob, especially a glass ceramic stove top, and/or an induction hob and/or a cooking oven and/or a steamer and/or a micro wave oven and/or a micro wave oven combi and/or a freestanding cooking device and/or a combi oven cook top. This makes it possible to implement a lot of functionality into the cooking device where, on the other side, no or at least only little additional space is required as the existing glass surface can be used.

In an advantageous embodiment, the position of the finger is displayed on a display and/or a screen, preferably by a cursor. This gives the operator a good feedback of his actions.

According to claim 8, the invention relates to a method for data input for a home appliance for operation with a finger, especially for an input device according to one of the preceding claims,
a) with sensitive keys arranged below a surface in a two-dimensional array,
b) wherein a key voltage is generated based on the nearness of the finger by each sensitive key dependant on the distance from the key and the size of the finger,
c) where all generated key voltages are compared,
d) wherein the position of the finger is detected,
e) wherein preferably the detection is repeated after a predefined time span and/or
f) wherein preferably a movement of the finger is detected.

Preferably, the position of the finger is detected by determining the largest key voltage.

In an advantageous embodiment, an acceleration of the finger movement is detected, especially by comparing three succeeding detected positions of the finger.

The invention will be now described in further details with references to the figures, in which
- FIG 1: shows an input device according to the invention,
- FIG 2: shows, as a detail, four sensitive keys with equivoltage lines,
- FIG 3: shows a block diagram of an input device according to the invention and in which
- FIG 4: shows an input device according to the invention integrated into an induction cooking hob.

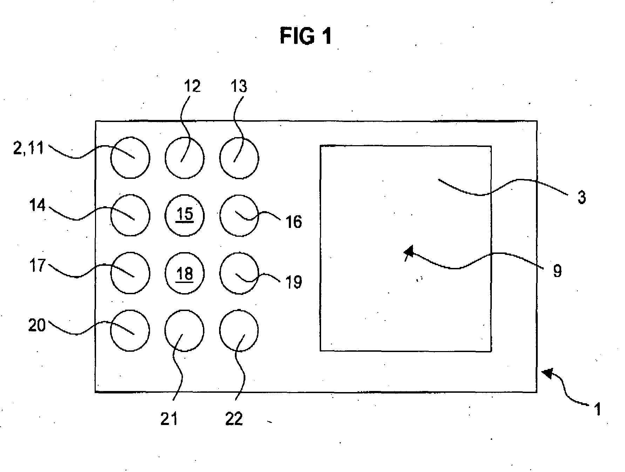

FIG 1 shows an input device 1 according to the invention, with a two-dimensional array 2 of sensitive keys 11 to 22 and a display 3 arranged beside the two-dimensional key array or matrix 2.

FIG 1 shows a matrix 2 of three rows and four columns (3 X 4) of keys 11 to 22, which are arranged in a rectangular form.

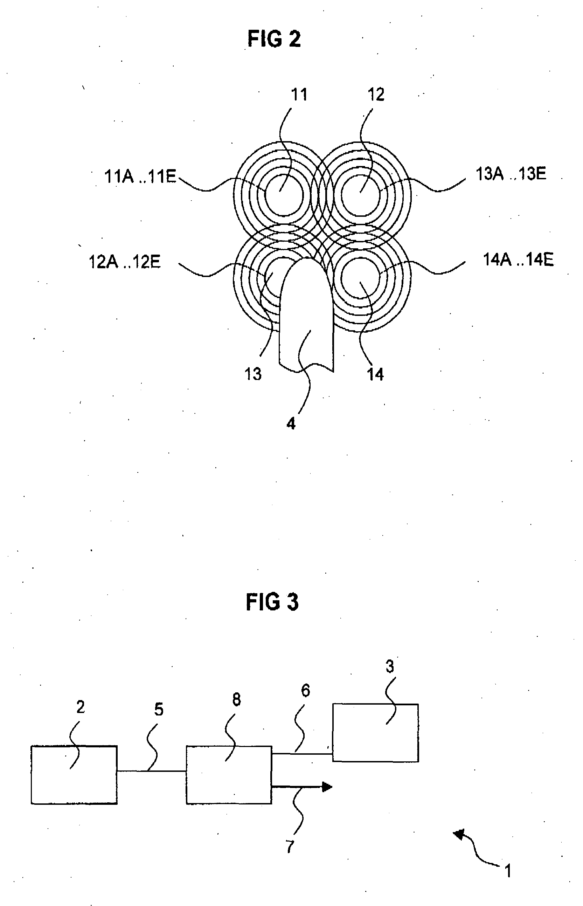

When the finger approaches to a sensitive key, a voltage is generated depending on the distance from the key. The generated voltages are then compared in a detection unit shown in FIG 3, where the highest voltage value defines the position of the finger 4 in the two dimensional array 2.

The input device 1 works similar like a mouse pad and moves an index on the display or screen 3 to select a different function.

The sensitive keys 11 to 22 are preferably implemented as capacitive keys. The capacitive areas of the keys 11 to 22 are arranged side by side in a nonoverlapping manner. This makes it possible to locate the position relative to the finger 4 with at least substantially good accuracy.

The keys 11 to 22 are at least substantially circular. As an alternative, the keys can also have another form.

For the input device 1, a fix center key can be defined, which is preferably in or near the center of the two-dimensional array 2, for example key 15. Relative to this key 15, a left, top, right and a bottom region are defined.

In this example, key 14 is in the left region, key 12 is in the top region, key 16 is in the right region and key 18 is in the bottom region. If the finger touches one of these keys, the cursor 9 on the display 3 will move into the corresponding direction.

The voltages are repeatedly generated and measured in predefined time spans, so that, by comparison of two succeeding detected values, the detection of the movement of the finger is also possible. A cursor 9 on the display 3 is moved in the detected direction. The detection of the movement can therefore also be executed based on an arbitrary starting point.

Also, the detection of an acceleration of the finger movement is possible. To detect the acceleration, at least three succeeding voltage values with the same time difference are compared, where the distance between the first and the second measurement is compared with the distance between the second and the third measurement.

Different finger sizes can generate different voltages in the sensitive keys. However, since the generated voltages are compared with each other, only the relative values of the sensitive keys are relevant.

For the array, different sizes are possible. Examples are 2 X 3, 3 X 3, 3 X 4, 4 X 4, or any other combination.

FIG 2 shows schematically which voltages are generated by the touch with the finger 4. The voltages generated by the sensitive keys 11 to 14 depend on the distance from the sensitive keys 11 to 14. Points where the same voltage is generated are arranged along circles around the sensitive key. FIG 2 shows such equivoltage lines 11A to 11E, 12A to 12E, 13A to 13E as well as 14A to 14E, which are generated depending on the distance of the finger 4 from the sensitive keys 11 to 14.

As an alternative, equivoltage lines can proceed along squares or rectangles or in other form around the sensitive keys, depending on the form of the keys.

FIG 3 shows a block diagram of the input device 1, with the key array 2 generating the voltage values of the keys, a detection unit 8 connected with the key array 2 by connection lines 5 detecting the closest sensitive key and the movement and/or the acceleration of the finger. The detected values are, on the one hand, passed via connection lines 6 to the display 3 and, on the other hand, passed to a further unit for further processing via connection lines 7.

According to a first example with a finger size of 7 mm, a voltage U13 is generated by key 13 with 350 mV, a voltage U14 is generated by key 14 with 120 mV and a voltage U11 is generated by key 11 with 50 mV. It will be detected, that the finger is on key 13 and close to key 14.

If the input device 1 is operated by a finger 4 with a diameter of 12 mm, a voltage U13 will be generated by key 13 with 400 mV, a voltage U14 will be generated by key 14 with 150 mV and a voltage U11 will be generated by key 11 with 70 mV. All voltage values are higher compared to the values generated by the finger with a size of 7 mm. But as the evaluation and detection is done by comparison, the result will be exactly the same. Also in this case, the finger on key 13 and close to key 14 will be detected. The measurements are taken every 100 ms.

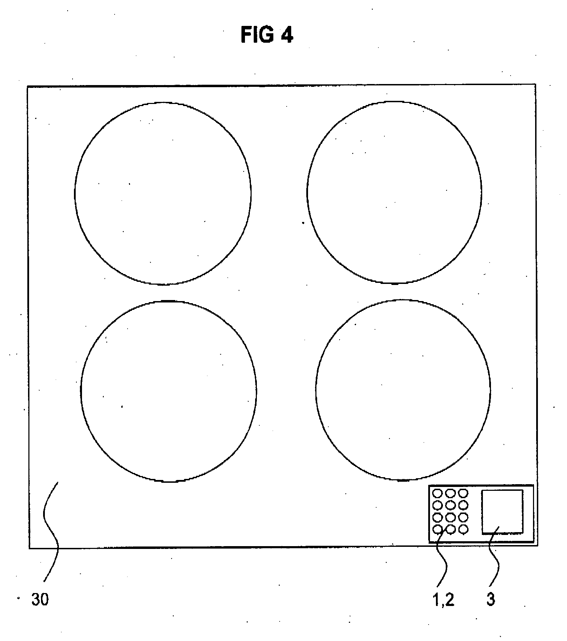

FIG 4 shows an input device 1 according to the invention integrated into an induction cooking hob 30. The induction cooking hob 30 comprises a transparent glass surface with back coating or enamelling. The input device 1 is arranged below the surface of the glass of the induction cooking hob 30. The sensitive keys in the key array 2 of the input device 1 can be operated from above the surface of the induction cooking hob 30.

As an alternative, the input can also be integrated into any other cooking hob, especially with transparent glass or outside the glass of a cooking hob.

### List of reference signs

- 1: input device
- 2: key array
- 3: display
- 4: finger
- 5 - 7: connection lines
- 8: detection unit
- 9: cursor
- 11 - 22: keys
- 11A - 11E,:
- 12A - 12E,:
- 13A - 13E,:
- 14A - 14E: equivoltage lines
- 30: induction hob

## Claims

1. Input device (1) for a home appliance for operation with a finger (4), comprising
a) sensitive keys (11 - 22) arranged below a surface in a two-dimensional array (2),
b) wherein a key voltage based on the nearness of the finger (4) is generatable by each sensitive key (11 - 22) dependant on the distance from the key and the size of the finger (4),
c) wherein in a detection unit (8) all key voltages are comparable and
d) wherein in the detection unit (8) the position of the finger (4) is detectable.

2. Input device according to claim 1,
a) wherein the detection of the position is repeatable after a predefined time span, especially 100 ms, and/or
b) wherein a movement of the finger (4) is detectable, preferably based on a fixed and/or an arbitrary starting point.

3. Input device according to claim 1 or 2, wherein the sensitive keys are at least substantially circular.

4. Input device according to one of the preceding claims, wherein the position of the finger is detectable by comparing the generated key voltages and determining the largest key voltage.

5. Input device according to one of the preceding claims, wherein an acceleration of the finger movement is detectable, especially by comparing three succeeding positions of the finger.

6. Input device according to one of the preceding claims, wherein the input device is integrated into a cooking device, particularly a, preferably transparent, glass of a cooking hob, especially a glass ceramic stove top, and/or an induction hob and/or a cooking oven and/or a steamer and/or a micro wave oven and/or a micro wave oven combi and/or a freestanding cooking device and/or a combi oven cook top.

7. Input device according to one of the preceding claims, wherein the position of the finger (4) is displayed on a display (3), preferably by a cursor (9).

8. Method for data input for a home appliance for operation with a finger (4), especially for an input device according to one of the preceding claims,
a) with sensitive keys (11 - 22) arranged below a surface in a two-dimensional array (2),
b) wherein a key voltage is generated based on the nearness of the finger by each sensitive key (11 - 22) dependant on the distance from the key and the size of the finger (4),
c) wherein all generated key voltages are compared,
d) wherein the position of the finger is detected,
e) wherein preferably the detection is repeated after a predefined time span and/or
f) wherein preferably a movement of the finger (4) is detected.

9. Method according to claim 8, wherein the position of the finger (4) is detected by determining the largest key voltage.

10. Method according to claim 8 or 9, wherein an acceleration of the finger movement is detected, especially by comparing three succeeding detected positions of the finger (4).
